# EUROPEAN PATENT SPECIFICATION

(11) **EP 3 426 012 B1**
(45) Date of publication and mention of the grant of the patent: **09.08.2023**
(21) Application number: 16892606.1
(22) Date of filing: 04.03.2016
(51) Int. Cl.: H05K 7/14, F24F 1/24, H05K 7/20, F24F 1/22

(54) **ELECTRIC COMPONENT MODULE AND OUTDOOR UNIT FOR AIR CONDITIONER**
ELEKTRISCHES KOMPONENTENMODUL UND AUSSENEINHEIT FÜR KLIMAANLAGE
MODULE DE COMPOSANT ÉLECTRIQUE ET UNITÉ EXTÉRIEURE POUR CLIMATISEUR

(43) Date of publication of application: 09.01.2019
(73) Proprietor: Mitsubishi Electric Corporation, Chiyoda-ku Tokyo 100-8310 (JP)
(72) Inventor: HAYAKAWA, Rei, Tokyo 102-0073 (JP); KAWAGUCHI, Yohei, Tokyo 102-0073 (JP); HATA, Shigeru, Tokyo 102-0073 (JP)
(74) Representative: Pfenning, Meinig & Partner mbB
(86) International application number: PCT/JP2016/056820
(87) International publication number: WO 2017/149766

(56) References cited:
- WO-A1-2007/108447
- WO-A1-2008/126390
- WO-A1-2008/126390
- WO-A1-2015/151544
- JP-A- H1 163 574
- JP-A- H03 168 544
- JP-A- H03 168 544
- JP-A- 2011 117 677
- JP-A- 2011 117 677
- JP-A- 2011 232 010
- JP-A- 2012 215 305

## Description

### Technical Field

The present invention relates to an electrical component module and an outdoor unit of an air-conditioning apparatus, and particularly relates to saving space therefor.

### Background Art

In a proposed method, substrates are mounted on both surfaces of a holder in order to save space for an electrical component module. For example, Patent Literature 1 discloses that a circuit substrate on which an electrical component capable of displaying the state of a control operation and other components are mounted is disposed on a front surface of a holder, and a circuit substrate on which a power element and other components are mounted is disposed on a back surface of the holder, thereby forming an electrical component module. At a lower portion of the circuit substrate disposed on the front surface of the holder provided at the electrical component module, a cooling path which allows refrigerant for a refrigerant circuit to circulate is provided. The cooling path is located on the opposite side of a side where the power element mounted on the circuit substrate disposed on the back surface is located, to thereby cool the power element and reduce heat generation.

WO 2015/151544A1 discloses an air conditioner outdoor unit comprising an electrical-part storage. The electrical-part storage comprises a board fixing member and a board attachment portion disposed perpendicular to the board fixing member at a bottom side of a surrounding wall of a partition-plate-side surface of the board fixing member. Therein a control board and a heat sink are held on a surface of the board attachment portion, and an auxiliary board is held on the surface of the board fixing member.

### Citation List

### Patent Literature

Patent Literature 1: Japanese Unexamined Patent Application Publication No. 2010-175231

### Summary of Invention

### Technical Problem

In the case where refrigerant cooling is adopted to cool a power element as in the electrical component module of Patent Literature 1, space for a cooling path needs to be provided in the electrical component module. In order to further save space in the electrical component module, it can be considered advantageous to apply instead of the refrigerant cooling, a method in which a heat sink to be connected with the power element is disposed in, for example, a surplus space located out of air-blowing of a fan in an air-blower chamber. However, in a structure in which a substrate provided with a power element mounted thereon is disposed on a back surface of a holder, it is not possible to ensure space for mounting a heat sink.

The present invention has been made to solve the above problem, and an object of the invention is to provide an electrical component module and an outdoor unit of an air-conditioning apparatus in each of which a power element is cooled by heat radiation by a heat sink and space can be saved.

### Solution to Problem

An electrical component module according to the invention is defined in claim 1.

### Advantageous Effects of Invention

In the electrical component module according to the present invention, a first substrate is disposed on a front surface of a first holder, and a second holder is disposed perpendicular to the first holder at an end portion of the first holder. In addition, the second holder is provided with a second substrate and a heat sink. The first substrate, the second substrate and a third substrate disposed on a back surface of the first holder are connected to each other by a line. By virtue of this configuration, it is possible to easily mount the heat sink, and save space in the electrical component module.

### Brief Description of Drawings

[Fig. 1] Fig. 1 is a perspective view illustrating an electrical component module according to an embodiment of the invention.
[Fig. 2] Fig. 2 is a perspective view illustrating the electrical component module according to the present embodiment as seen from below with respect to a back surface of the electrical component.
[Fig. 3] Fig. 3 is a perspective view illustrating a first holder of the electrical component module according to the present embodiment as seen from below with respect to the back surface.
[Fig. 4] Fig. 4 is a perspective view illustrating how a large-sized circuit substrate is held by the first holder as seen from below with respect to the back surface.
[Fig. 5] Fig. 5 is an exploded perspective view illustrating an outdoor unit of an air-conditioning apparatus according to the present embodiment.

### Description of Embodiment

### Embodiment

An electrical component module according to the present embodiment and structural elements of an outdoor-side heat exchanger, an outdoor air-blower and a compressor form an outdoor unit of an air-conditioning apparatus. In the outdoor unit of the air-conditioning apparatus, the structural elements are accommodated in a housing formed by five external panels covering a front surface, a back surface, a right surface, a left surface and an upper surface of the outdoor unit. The outdoor-side heat exchanger and the outdoor air-blower are disposed in an air blower chamber located on the left side, and the electrical component module and the compressor are disposed in a machine chamber located on the right side.

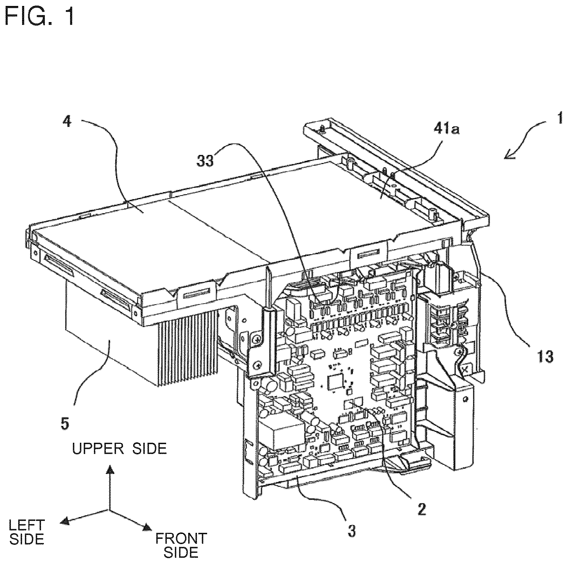

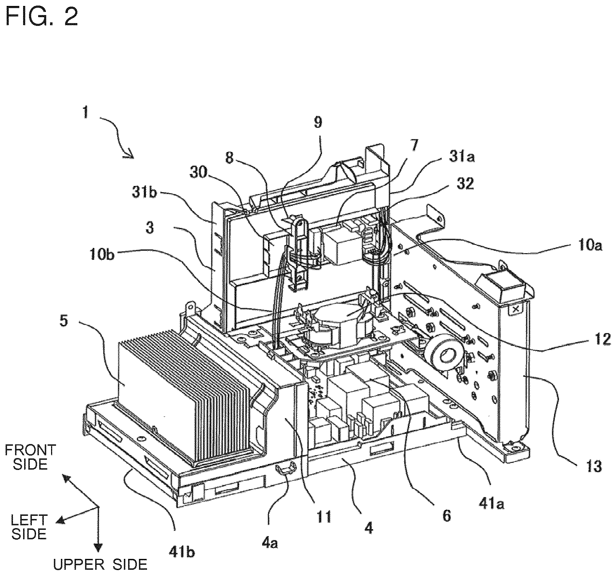

Fig. 1 is a perspective view illustrating an electrical component module 1 according to the present embodiment. Fig. 2 is a perspective view illustrating the electrical component module 1 according to the present embodiment as seen from below with respect to a back surface of the electrical component module 1. As illustrated in Figs. 1 and 2, the electrical component module 1 includes a first holder 3, a control substrate 2, a circuit substrate 7, a second holder 4, a power substrate 6 and a heat sink 5, the control substrate 2 and the circuit substrate 7 being held by the first holder 3, the power substrate 6 and the heat sink 5 being held by the second holder 4. The electrical component module 1 also includes a protection cover 11, a terminal block holder 13 to which a terminal block is attached, and electrical components 12 such as a reactor. The control substrate 2, the power substrate 6, and the circuit substrate 7 are examples of a first substrate, a second substrate and a third substrate of the present invention, respectively.

The first holder 3 has substrate holding structures on the front and back sides of the outdoor-side heat exchanger, and holds the control substrate 2 on a front surface and the circuit substrate 7 on a back surface. The front surface and the back surface are examples of a first surface portion and a second surface portion of the present invention, respectively. The holding structures of the first holder 3 are, for example, hooks which are to be engaged with the control substrate 2 and the circuit substrate 7 to fix them. To be more specific, the hooks are engaged with peripheral portions of the control substrate 2 and the circuit substrate 7, thereby holding the control substrate 2 and the circuit substrate 7. On the control substrate 2 held on the front surface, for example, an electrical component which displays an operation status of the outdoor unit of the air-conditioning apparatus, etc., is mounted. The control substrate 2 is provided inward of the external panel located on the front side, and is located at such a position that it can be maintained after being set, by opening an openable portion of the external panel.

The first holder 3 includes side edge portions 31a and 31b. At the side edge portion 13a, which is close to the right surface of the housing, the terminal block holder 13 is disposed perpendicular to the side edge portion 31a. The terminal block holder 13 is connected to lines for power supply and communication between an indoor unit and the outdoor unit. The lines extending through the terminal block holder 13 are connected to, for example, the control substrate 2, the power substrate 6, the circuit substrate 7 and the electrical components 12. In part of the first holder 3 which is close to the side edge portion 31a, a hole 32 which allow lines 10a to pass therethrough is provided, and lines 10a to be connected with the control substrate 2 are made to pass through the hole 32.

The second holder 4 is located inward of the external panel on the upper side of the housing, and in parallel to this external panel. On a back surface side of an upper end portion 33 of the back surface of the first holder 3, the second holder 4 is disposed perpendicular to the first holder 3. A seen in front view, of side edge portions of the second holder 4, a side edge portion 41a is located above the side edge portion 31a of the first holder 3 at which the terminal block holder 13 is disposed, and the other side edge portion, i.e., a side edge portion 41b, is located leftward of the side edge portion 31b of the first holder 3. On a side closer to the side edge portion 41a of the lower surface side of the second holder 4, a substrate holding structure such as a hook is provided as in the first holder 3. The hook is engaged with the power substrate 6, thereby fixing the power substrate 6. On the other side, i.e., a side closer to the side edge portion 41b, the heat sink 5 is disposed. On a back surface of a lower surface side of the second holder 4, a claw portion 4a for attaching the second holder 4 to the housing is formed. It suffices that the substrate holding structure is provided at least on the lower surface side. However, the substrate holding structure may be provided on both the upper and lower surface sides of the second holder 4 as in the first holder 3.

The power substrate 6 is a substrate on which heat-generating electronic components such as power elements including an inverter circuit, a fan drive element, and a capacitor are mounted. The power substrate 6 is connected to the circuit substrate 7, supplied with power through lines 10b, and transmits and receives a control signal, whereby its operation is controlled. The heat sink 5 is disposed close to the power substrate 6, and leftward thereof. The heat sink 5 is mounted as a cooling unit which dissipates heat from the power substrate 6. The protection cover 11 is attached between the power substrate 6 and the heat sink 5. The protection cover 11 protects connection between the power substrate 6 and the heat sink 5 when the claw portion 4a of the second holder 4 is engaged with and attached to a partition plate of the outdoor unit of the air-conditioning apparatus.

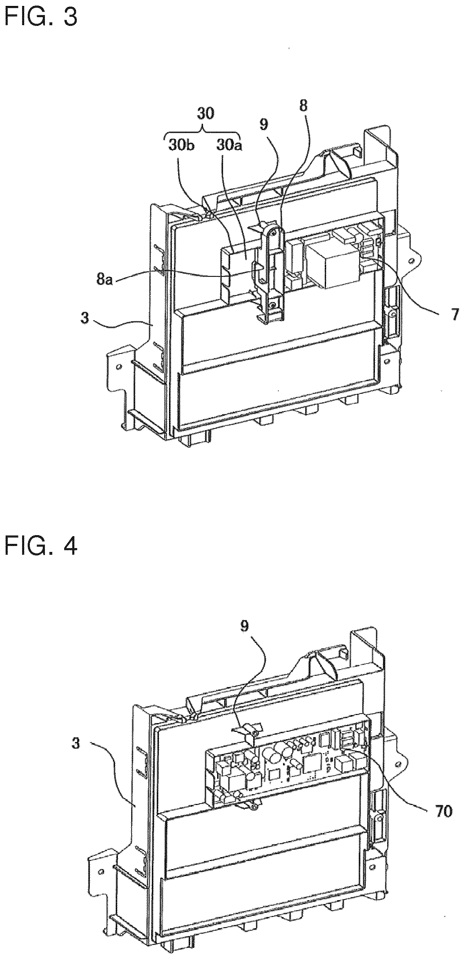

Fig. 3 is a perspective view illustrating the first holder 3 of the electrical component module 1 according to the present embodiment as seen from below with respect to the back surface. As illustrated in Fig. 3, the circuit substrate 7 fitted in a recess 30 and fixed by a fixation member 8 and the electrical components 12 are disposed on the back surface of the first holder 3. The circuit substrate 7 is a substrate which receives a signal for reducing power consumption, which is transmitted from the outside. The circuit substrate 7 is connected, by lines, to the control substrate 2 located on the back surface of the circuit substrate 7 and the power substrate 6 located on the lower surface of the second holder 4. Electronic components such as a CPU and a memory are mounted on the circuit substrate 7. Also, as the electrical components 12, electronic components such as a reactor and a noise filter are mounted on the circuit substrate 7. On the back surface of the first holder 3, on which the circuit substrate 7 is held, the recess 30 is rectangularly formed. The recess 30 is surrounded by a rectangular fixation surface 30a and a wall surface 30b protruding in a thickness direction of the first holder 3 and provided with a hook. On the fixation surface 30a, the circuit substrate 7 is provided, and the hook of the wall surface 30b is engaged with the peripheral portion of the circuit substrate 7. The fixation member 8 is fixed to the first holder 3 by a screw, in a screw hole 9 formed in the first holder 3, and holds the circuit substrate 7 in cooperation with the wall surface 30b. A hook portion 8a is formed in the fixation member 8, and lines connecting the circuit substrate 7 and the power substrate 6 are collected and hooked over the hook portion 8a.

Fig. 4 is a perspective view illustrating how a large-size circuit substrate 70 is held by the first holder 3 as seen from below with respect to the back surface. As illustrated in Fig. 4, in place of the circuit substrate 7, a substrate to be connected with a centralized controller capable of controlling operations of a plurality of indoor units in a lump may be provided as the large-size circuit substrate 70, in the recess 30 of the first holder 3. Alternatively, a sub substrate smaller in size than the large-size circuit substrate 70 may be mounted in addition to the circuit substrate 7, such that the resultant structure has a function equivalent to that of the large-size circuit substrate 70. It should be noted that the sub substrate is an example of the fourth substrate of the present invention. In an embodiment not covered by the present invention, in the case where the large-size circuit substrate 70 larger in size than the circuit substrate 7 is held by the first holder 3, the fixation member 8 is removed, and the large-size circuit substrate 70 is placed on the entire surface of the fixation surface 30a and held by the wall surface 30b. Also, in another embodiment not covered by the present invention, in the case where the circuit substrate 7 and the sub substrate are mounted, the fixation member 8 of the first holder 3 is removed, and the circuit substrate 7 and the sub substrate are disposed adjacent to each other on the fixation surface 30a. In an embodiment not covered by the present invention, in the case where a substrate is disposed in a region extending to both side edge portions 31a and 31b of the first holder 3 as the large-size circuit substrate 70 is disposed, it is fixed by the fixation member 8. In this case, the hook portion 8a of the fixation member 8, which collectively holds lines between the circuit substrate 7 and the power substrate 6, is unnecessary, since the large-size circuit substrate 70 and the power substrate 6 are disposed close to each other.

In such a manner, in the electrical component module 1 according to the present embodiment, the control substrate 2 and the circuit substrate 7 are held by the front and back surfaces of the first holder 3, and the power substrate 6 and the heat sink 5 are held by the lower surface of the second holder 4 disposed at an upper end of the first holder 3. By virtue of this configuration, heat radiation from the power substrate 6 can be carried out by the heat sink 5, and space in a machine chamber 102 can be saved. Furthermore, since the circuit substrate 7 is disposed close to the control substrate 2 and the power substrate 6, it can be easily connected to the control substrate 2 and the power substrate 6 by lines, and the lines connected to the circuit substrate 7 can be shortened. In the back surface of the first holder 3, the recess 30 for holding the circuit substrate 7 is provided. The circuit substrate 7 is engaged and fixed by the hook of the recess 30. Even in the case where the function of the circuit substrate 7 is extended, and the size thereof is thus changed, the circuit substrate 7 is fixed by adjusting the size of the recess 30 with the fixation member 8. According to the invention, the lines connecting the circuit substrate 7 and the power substrate 6 are collectively hooked on the hook portion 8a of the fixation member 8.

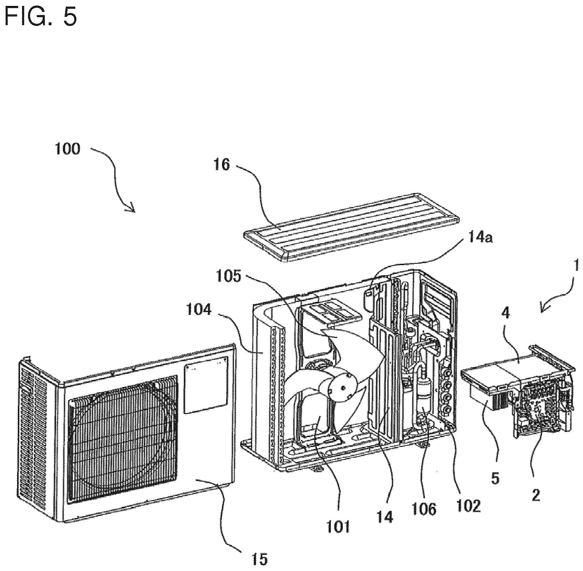

It will be described how the electrical component module 1 is attached to the outdoor unit of the air-conditioning apparatus. Fig. 5 is an exploded perspective view of an outdoor unit 100 of the air-conditioning apparatus according to the present embodiment. As illustrated in Fig. 5, the electrical component module 1 is attached within the outdoor unit 100 of the air-conditioning apparatus to which back-side and right-side external panels 15 and a partition plate 14 that partitions the inside of the housing are attached. The housing is partitioned into an air blower chamber 101 and the machine chamber 102 by the partition plate 14, the air-blower chamber accommodating an outdoor-side heat exchanger 104 and an outdoor air-blower 105, the machine chamber 102 accommodating a compressor 106. In the case of attaching the electrical component module 1, first, the electrical component module 1 is disposed such that the control substrate 2 is disposed on the front side of the machine chamber 102, and the control substrate 2 on the first holder 3 faces a front-side external panel 15. Then, the claw portion 4a provided on the back surface of the second holder 4 is caught on a catch portion 14a formed on the partition plate 14, the second holder 4 is placed on an upper end portion of the partition plate 14, and the electrical component module 1 and the machine chamber 102 are fastened to each other by a screw. Thereafter, the front-side external panel 15 and a left-side external panel 15 of the housing are attached from the right side on the front side while being engaged with the right-side external panel 15 of the housing, and an upper-side external panel 16 is placed from above. As a result, in the outdoor unit 100 of the air-conditioning apparatus, the electrical component module 1 is attached to the outdoor unit 100 of the air-conditioning apparatus, while the heat sink 5 is projected closer to the air blower chamber 101, and components of the electrical component module 1 which are other than the heat sink 5 are accommodated in the machine chamber 102.

It should be noted that although the above description is given by referring to by way of example the case where the electrical component module 1 is attached to the outdoor unit 100 of the air-conditioning apparatus, the electrical component module 1 can also be attached to an electronic apparatus other than the outdoor unit 100 of the air-conditioning apparatus, on which a power element is mounted.

In the above electrical component module 1 according to the present embodiment, there are provided the first holder 3 including substrate holding structures on its front and back surfaces, and the second holder 4 disposed perpendicular to the first holder 3 at the upper end portion 33 of the back surface of the first holder 3. The control substrate 2 is held on the front surface of the first holder 3, the power substrate 6 and the heat sink 5 are held by the second holder 4, and the circuit substrate 7 connected to the control substrate 2 and the power substrate 6 by lines is held on the back surface of the first holder 3. In such a manner, since the power substrate 6 and the heat sink 5 are held on the lower surface of the second holder 4, the heat sink 5 can be easily mounted. Furthermore, since the heat sink 5 is disposed close to the power substrate 6, it is possible to achieve heat radiation by the heat sink 5, and make the electrical component module 1 smaller. In addition, since the distance between the circuit substrate 7 and each of the control substrate 2 and the power substrate 6, which are connected to the circuit substrate 7, is shortened, the components can be easily connected to each other by lines, and the distance between they are connected together by the lines can be shortened.

In the electrical component module 1 according to the present embodiment, the fixation member 8 which fixes the substrate to the first holder 3 is provided.
Because of provision of the fixation member 8, even if each of circuit substrates 7 having different sizes is applied, it can be fitted in and held by the back surface of the first holder 3.

In the electrical component module 1 according to the present embodiment, the fixation member 8 includes the hook portion 8a for collecting up lines connected to the circuit substrate 7. Thereby, even in the case where the circuit substrate 7 and the power substrate 6 are not close to each other, since the lines can be collected up, they can be prevented from contacting other lines.

In the electrical component module 1 according to the present embodiment, the recess 30 is formed in the back surface of the first holder 3, and the circuit substrate 7 is fixed by the recess 30. In such a manner, the circuit substrate 7 is held on the first holder 3 by fitting the circuit substrate 7 in the recess 30 of the first holder 3.

In the electrical component module 1 according to the present embodiment, a sub circuit substrate is further provided. The circuit substrate 7 and the sub circuit substrate are held adjacent to each other on the back surface of the first holder 3. Thereby, a plurality of circuit substrates 7 can be fitted in the back surface of the first holder 3, even though they are of different kinds.

In the electrical component module 1 according to the present embodiment, even in the case where a power element is mounted on the power substrate 6, the power substrate 6 is mounted separately from the control substrate 2 and the circuit substrate 7. It is therefore possible that the power substrate 6 and the heat sink 5 are disposed on the second holder 4, and the control substrate 2 and the circuit substrate 7 are disposed on the first holder 3. Accordingly, space can be saved.

In the outdoor unit 100 of the air-conditioning apparatus according to the present embodiment, the electrical component module 1, the outdoor-side heat exchanger 104, the outdoor air-blower 105 and the compressor 106 are provided. Since the electrical component module 1 is made smaller, the outdoor unit 100 of the air-conditioning apparatus can also be made smaller; and since the control substrate 2 is located on the front side, the maintenance thereof can be easily carried out. In addition, the outdoor unit can be easily assembled on an assembly line.

### Reference Signs List

1 electrical component module 2 control substrate 3 first holder
4 second holder 4a claw portion 5 heat sink 6 power substrate
7 circuit substrate 8 fixation member 8a hook portion 9 screw hole 10a, 10b line 11 protection cover 12 electrical component
13 terminal block holder 14 partition plate 14a catch portion
15 external panel 16 external panel 30 recess 30a fixation surface 30b wall surface 31a, 31b, 41a, 41b side edge portion
32 hole 33 upper end portion 70 large-size circuit substrate
100 outdoor unit 101 air blower chamber 102 machine chamber
104 outdoor-side heat exchanger 105 outdoor air-blower 106 compressor

## Claims

1. An electrical component module (1) comprising:
a first holder (3) having substrate holding structures on a first surface portion and a second surface portion located on a back-surface side of the first surface portion;
a second holder (4) disposed perpendicular to the first holder (3) at an end portion of the second surface portion of the first holder (3), and having a substrate holding structure on one surface of the second holder (4);
a first substrate (2) held on the first surface portion of the first holder (3);
a second substrate (6) and a heat sink (5) both held by the second holder (4);
a third substrate (7) held on the second surface portion of the first holder (3), and connected to the first substrate (2) and the second substrate (6) by lines (10a); and
further comprising a fixation member (8) configured to fix the third substrate (7) to the first holder (3),
wherein the fixation member (8) includes a hook portion (8a) over which a line (10a) connecting the second substrate (6) and the third substrate (7) is to be hooked.

2. The electrical component module (1) of claim 1, wherein
a recess (30) is formed in the second surface portion of the first holder (3), and
the third substrate (7) is fixed by the recess (30).

3. The electrical component module (1) of claim 2, further comprising a fourth substrate (70), wherein the third substrate (7) and the fourth substrate (70) are held by the recess (30).

4. The electrical component module (1) according to any one of claims 1 to 3,
wherein the second substrate (6) is a power substrate (6) on which a power element is mounted.

5. An outdoor unit (100) of an air-conditioning apparatus, comprising the electrical component module (1) according to any one of claims 1 to 4, an outdoor-side heat exchanger (104), an outdoor air-blower (105), and a compressor (106).

## Patentansprüche

1. Elektrobauteilmodul (1), umfassend:
einen ersten Halter (3) mit Substrat-Haltestrukturen auf einem ersten Oberflächenabschnitt und einem zweiten Oberflächenabschnitt, der sich auf einer Rückseite des ersten Oberflächenabschnitts befindet;
einen zweiten Halter (4), der senkrecht zu dem ersten Halter (3) an einem Endabschnitt des zweiten Oberflächenabschnitts des ersten Halters (3) angeordnet ist und eine Substrat-Haltestruktur auf einer Oberfläche des zweiten Halters (4) aufweist;
ein erstes Substrat (2), das auf dem ersten Oberflächenabschnitt des ersten Halters (3) gehalten wird;
ein zweites Substrat (6) und einen Kühlkörper (5), die beide von dem zweiten Halter (4) gehalten werden;
ein drittes Substrat (7), das auf dem zweiten Oberflächenabschnitt des ersten Halters (3) gehalten wird und mit dem ersten Substrat (2) und dem zweiten Substrat (6) durch Leitungen (10a) verbunden ist; und
ferner umfassend ein Befestigungselement (8), das eingerichtet ist, das dritte Substrat (7) an dem ersten Halter (3) zu befestigen,
wobei das Befestigungselement (8) einen Hakenabschnitt (8a) aufweist, über den eine das zweite Substrat (6) und das dritte Substrat (7) verbindende Leitung (10a) eingehakt werden soll.

2. Elektrobauteilmodul (1) nach Anspruch 1, wobei
eine Aussparung (30) in dem zweiten Oberflächenabschnitt des ersten Halters (3) ausgebildet ist und
das dritte Substrat (7) durch die Aussparung (30) befestigt ist.

3. Elektrobauteilmodul (1) nach Anspruch 2, ferner umfassend ein viertes Substrat (70), wobei das dritte Substrat (7) und das vierte Substrat (70) von der Aussparung (30) gehalten werden.

4. Elektrobauteilmodul (1) nach einem der Ansprüche 1 bis 3, wobei das zweite Substrat (6) ein Energiesubstrat (6) ist, auf dem ein Energieelement angebracht ist.

5. Außeneinheit (100) einer Klimaanlage, umfassend das Elektrobauteilmodul (1) nach einem der Ansprüche 1 bis 4, einen außenseitigen Wärmetauscher (104), ein Außenluftgebläse (105) und einen Verdichter (106).

## Revendications

1. Module de composant électrique (1) comprenant :
un premier support (3) comportant des structures de maintien du substrat sur une première partie de surface et une seconde partie de surface située sur la face arrière de la première partie de surface ;
un second support (4) disposé perpendiculairement au premier support (3) à une extrémité de la seconde surface du premier support (3), et comportant une structure de maintien du substrat sur une surface du second support (4) ;
un premier substrat (2) maintenu sur la première partie de la surface du premier support (3) ;
un deuxième substrat (6) et un dissipateur thermique (5) tous deux maintenus par le second support (4) ;
un troisième substrat (7) maintenu sur la seconde partie de la surface du premier support (3) et relié au premier substrat (2) et au deuxième substrat (6) par des lignes (10a) ; et
comprenant en outre un élément de fixation (8) configuré pour fixer le troisième substrat (7) au premier support (3),
dans lequel l'élément de fixation (8) comprend une partie de crochet (8a) sur laquelle une ligne (10a) reliant le deuxième substrat (6) et le troisième substrat (7) doit être accrochée.

2. Module de composant électrique (1) selon la revendication 1, dans lequel
une cavité (30) est formée dans la deuxième partie de la surface du premier support (3), et
le troisième substrat (7) est fixé par la cavité (30).

3. Module de composant électrique (1) selon la revendication 2, comprenant en outre un quatrième substrat (70), dans lequel le troisième substrat (7) et le quatrième substrat (70) sont maintenus par la cavité (30).

4. Module de composant électrique (1) selon l'une quelconque des revendications 1 à 3, dans lequel le deuxième substrat (6) est un substrat électrique (6) sur lequel un élément électrique est monté.

5. Unité extérieure (100) d'un appareil de climatisation, comprenant le module de composants électriques (1) selon l'une quelconque des revendications 1 à 4, un échangeur de chaleur côté extérieur (104), une soufflerie d'air extérieur (105) et un compresseur (106).
